# FASCICULE DE BREVET EUROPEEN

(11) **EP 2 887 384 B1**
(45) Date de publication et mention de la délivrance du brevet: **09.02.2022**
(21) Numéro de dépôt: 14199888.0
(22) Date de dépôt: 22.12.2014
(51) Int. Cl.: H01L 21/20, H01L 29/78, H01L 21/84, H01L 27/12, H01L 29/04

(54) **Procédé amélioré de réalisation de blocs semi-conducteurs contraints sur la couche isolante d'un substrat semi-conducteur sur isolant**
Verbessertes Verfahren zur Herstellung von Halbleiterblöcken, die auf der Isolierschicht eines Halbleitersubstrats auf Isoliermaterial gespannt sind
Improved method for producing stressed semiconductor blocks on the insulating layer of a semiconductor on insulator substrate

(30) Priorité: 23.12.2013 FR 1363418
(43) Date de publication de la demande: 24.06.2015
(73) Titulaire: Commissariat à l'Énergie Atomique et aux Énergies Alternatives, 75015 Paris (FR)
(72) Inventeur: Reboh, Shay, 38360 SASSENAGE (FR); Batude, Perrine, 21000 DIJON (FR); Maitrejean, Sylvain, 38000 GRENOBLE (FR); Mazen, Frédéric, 38120 SAINT EGREVE (FR)
(74) Mandataire: Brevalex

(56) Documents cités:
- WO-A1-2008/014032
- US-A1- 2007 012 960
- James B. Kuo ET AL: "CMOS VLSI Engineering Silicon-on-Insulator (SOI)" In: "CMOS VLSI Engineering Silicon-on-Insulator (SOI)", 1 janvier 1998 (1998-01-01), Kluwer Academic Publishers, Dordrecht, the Netherlands, XP055142890, pages 38-39, * pages 38-39 *
- THOMPSON S E ET AL: "Uniaxial-process-induced strained-Si: extending the CMOS roadmap", IEEE TRANSACTIONS ON ELECTRON DEVICES IEEE USA, vol. 53, no. 5, mai 2006 (2006-05), pages 1010-1020, XP002730256, ISSN: 0018-9383

## Description

### DOMAINE TECHNIQUE ET ART ANTERIEUR

La présente description concerne le domaine des structures formées d'un substrat de type semi-conducteur sur isolant, et plus particulièrement celui des dispositifs dotés d'un substrat de type semi-conducteur sur isolant sur lequel plusieurs zones semi-conductrices ayant des contraintes mécaniques différentes ou subissant des déformations différentes sont formées.

Par déformation mécanique on entend un matériau qui a son ou ses paramètre(s) de maille cristalline allongé(s) ou écourté(s).

Dans le cas où le paramètre de maille déformé est plus important que le paramètre dit « naturel » du matériau cristallin, celui-ci est dit en déformation tensive ou en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Pour certaines applications, en particulier pour la réalisation de transistors, il peut être avantageux de prévoir une couche de matériau semi-conducteur contraint.

Une contrainte en tension ou en compression sur une couche semi-conductrice permet d'induire une augmentation de la vitesse des porteurs de charges, améliorant ainsi les performances de dispositifs à transistors formés dans une telle couche.

Un substrat de type semi-conducteur sur isolant est communément formé d'une couche de support recouvert par, et en contact avec, une couche isolante, elle-même recouverte par, et en contact avec, une couche superficielle semi-conductrice généralement destinée à servir de couche active c'est-à-dire dans laquelle au moins une partie de composants électroniques tels que des transistors est destinée à être formée.

Il est connu de réaliser des substrats de type semi-conducteur contraint sur isolant, dans lesquels le matériau de la couche superficielle semi-conductrice reposant sur la couche isolante est à base d'un matériau contraint.

On sait par exemple réaliser des substrats de type sSOI (pour « strained Silicon On Insulator » ou silicium contraint sur isolant) comportant une couche superficielle de silicium contraint en tension dans le plan dans laquelle des transistors de type N ayant des performances améliorées peuvent être formés. Une telle contrainte est cependant défavorable aux transistors de type P.

Il est également connu de réaliser des dispositifs dans lesquels, sur un même support, un ou plusieurs transistors sont contraints en tension tandis qu'un ou plusieurs transistors sont contraints en compression.

Le document US 2012/0068267 A1 prévoit par exemple un procédé dans lequel on forme un transistor de type NMOS contraint en tension et un transistor de type PMOS contraint en compression sur un même substrat.

Dans ce procédé, pour former un bloc semi-conducteur contraint en tension, on forme une zone de SiGe sur un bloc de Si sur isolant dont on rend amorphe une région inférieure que l'on recristallise ensuite. Lors de la recristallisation, le SiGe impose son paramètre de maille au Si afin de former un bloc semi-conducteur contraint en tension destiné à former un canal d'un transistor de type N. Un autre bloc de Si destiné à former un canal d'un transistor de type P est quant à lui contraint en compression par le biais d'un enrichissement en Germanium.

Un tel procédé a pour inconvénient d'être limité à la mise en contrainte en tension de Si et à la mise en en contrainte en compression de SiGe, et de nécessiter pour cela de réaliser une croissance de SiGe qui peut s'avérer à la fois couteuse et difficile à mettre en œuvre.

Une autre méthode de fabrication d'un dispositif semi-conducteur comprenant des régions de différentes contraintes est connue de US 2007/0012960 A1.

Par ailleurs, un tel procédé nécessite de nombreuses étapes et notamment de devoir utiliser des procédés différents pour réaliser une mise en contrainte en tension et une mise en contrainte en compression.

Il se pose le problème de trouver un nouveau procédé permettant la mise en œuvre, sur un même substrat, de zones semi-conductrices ayant des contraintes différentes et qui ne comporte pas les inconvénients mentionnés ci-dessus.

### EXPOSÉ DE L'INVENTION

La présente invention concerne tout d'abord un procédé de réalisation d'une structure semi-conductrice comprenant des étapes consistant à
a) former sur une couche à base de matériau amorphe, un premier bloc semi-conducteur recouvert d'une première zone de contrainte à base d'un matériau amorphe contraint en tension adapté pour induire un premier état de contrainte dans ledit premier bloc et un deuxième bloc semi-conducteur recouvert d'une deuxième zone de contrainte à base d'un matériau amorphe contraint en compression adapté pour induire un deuxième état de contrainte dans ledit deuxième bloc, le premier bloc étant formé d'une région inférieure à base de matériau semi-conducteur amorphe, recouverte d'une région supérieure de matériau semi-conducteur cristallin en contact avec ladite première zone de contrainte, le deuxième bloc étant formé d'une région inférieure à base de matériau semi-conducteur amorphe, la région inférieure étant recouverte d'une région supérieure de matériau semi-conducteur cristallin en contact avec la deuxième zone de contrainte,
b) recristalliser la région inférieure du premier bloc et la région inférieure du deuxième bloc en servant de la région supérieure de matériau cristallin comme zone de départ à un front de recristallisation.

La couche de matériau amorphe sur laquelle le premier bloc et le deuxième bloc sont formés, peut être une couche isolante d'un substrat de type semi-conducteur sur isolant.

Les régions supérieures de matériau semi-conducteur cristallin du premier bloc et du deuxième bloc qui ne sont pas rendues amorphes sont, de par leur proximité avec les zones de contraintes celles des blocs semi-conducteurs dans lesquelles les déformations dans le plan sont les plus importantes.

On se sert de ces régions cristallines contraintes comme germes de départ à une recristallisation des régions inférieures des blocs semi-conducteurs afin d'imposer le paramètre de maille des régions supérieures aux régions inférieures et créer ainsi une déformation élastique permanente dans les régions inférieures.

Un procédé dans lequel on réalise amorphisation de la région inférieure en se servant ensuite de la région supérieure dont on a conservé la structure cristalline pour recristalliser cette région inférieure permet d'obtenir un meilleur transfert de contrainte qu'un procédé dans lequel on ferait l'inverse i.e. que l'on rendrait amorphe une région supérieure en se servant ensuite d'une région inférieure dont on a conservé la structure cristalline pour recristalliser la région supérieure.

On peut ensuite retirer les zones de contrainte.

Un matériau contraint amorphe pour former la première zone de contrainte et la deuxième zone de contrainte, permet de pouvoir contraindre différents types de matériaux semi-conducteurs, tels que par exemple du Si, du Ge, du SiGe, du InP du GaAs.

L'utilisation d'un matériau amorphe permet également de pouvoir réaliser des zones de contrainte d'épaisseur importante et qui n'est pas limitée par des phénomènes de relaxation plastique comme avec un matériau cristallin. Cela permet donc d'avoir un plus fort rapport de volume entre la zone de contrainte et le bloc semi-conducteur contraint, donc un meilleur transfert de contraintes ou de déformations de la zone contrainte vers le bloc semi-conducteur.

Un tel procédé peut permettre également d'effectuer la recristallisation et mise en contrainte du premier bloc et du deuxième bloc en même temps ou simultanément.

Le premier état de contrainte du premier bloc semi-conducteur peut être un état de contrainte en compression, tandis que le deuxième état de contrainte du deuxième bloc semi-conducteur peut être un état de contrainte en tension.

Le premier bloc et ledit deuxième bloc formés à l'étape a) peuvent être avantageusement à base du même matériau semi-conducteur. Ce matériau semi-conducteur peut être par exemple du Si ou du Ge

Ainsi, avec un procédé suivant l'invention on peut former des blocs de matériau semi-conducteurs contraints selon des types de contraintes différentes, tout en limitant le nombre d'étapes et le coût du procédé.

Le matériau contraint amorphe peut être avantageusement à base de Nitrure de Silicium, ou de Nitrure de Titane, ou de carbone.

Un tel procédé permet également de limiter le nombre d'étapes de croissance par épitaxie.

Selon une mise en œuvre particulière du procédé, on réalise entre l'étape a) et l'étape b), au moins un recuit thermique à une température inférieure à la température de recristallisation du matériau semi-conducteur amorphe et adaptée pour permettre une mise sur contrainte de la région supérieure cristalline non amorphisée du bloc semi-conducteur préalablement à la recristallisation des régions redues amorphes.

A l'aide d'un tel recuit, on peut modifier davantage le niveau de déformation dans les blocs semi-conducteurs.

Selon un aspect particulier du procédé, l'amorphisation de ladite région inférieure dudit premier bloc peut être réalisée simultanément ou en même temps que celle dudit deuxième bloc.

Selon une première possibilité de mise en œuvre, l'étape a) peut comprendre au moins une implantation ionique amorphisante de ladite région inférieure dudit premier bloc et dudit deuxième bloc.

Cette implantation est alors réalisée de manière à conserver la structure cristalline de ladite région supérieure dudit premier bloc et dudit deuxième bloc.

Selon une deuxième possibilité de mise en œuvre, l'étape a) peut comprendre une gravure d'un empilement formé d'une couche de matériau semi-conducteur cristallin reposant sur une couche de matériau semi-conducteur amorphe. Cet empilement peut avoir été préalablement formé par :
- réalisation d'une couche de matériau semi-conducteur amorphe sur une couche de matériau cristallin d'un premier substrat,
- collage de ladite couche de matériau semi-conducteur amorphe sur une couche isolante superficielle recouvrant un deuxième substrat.

Après collage, une épaisseur du premier substrat peut être retirée.

La couche de matériau semi-conducteur amorphe sur le premier substrat peut être réalisée par dépôt ou par implantation ionique amorphisante d'une couche de matériau semi-conducteur cristallin.

La réalisation de ladite première zone de contrainte et/ou de la deuxième zone de contrainte peut comprendre des étapes de :
- dépôt d'une couche de matériau contraint sur ledit premier bloc et sur ledit deuxième bloc,
- formation d'un masquage recouvrant un bloc donné parmi le premier bloc et le deuxième bloc recouverts par le matériau contraint, une ouverture du masquage dévoilant l'autre bloc parmi le premier et le deuxième bloc,
- gravure de cet autre bloc à travers l'ouverture du masquage.

Selon une variante de mise en œuvre du procédé dans lequel ledit substrat est un substrat de type semi-conducteur contraint en tension sur isolant, le premier état de contrainte dans ledit premier bloc peut être tel que le premier bloc est relaxé ou contraint en compression tandis que le deuxième état de contrainte dans ledit deuxième bloc est tel que le deuxième bloc est contraint en tension.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

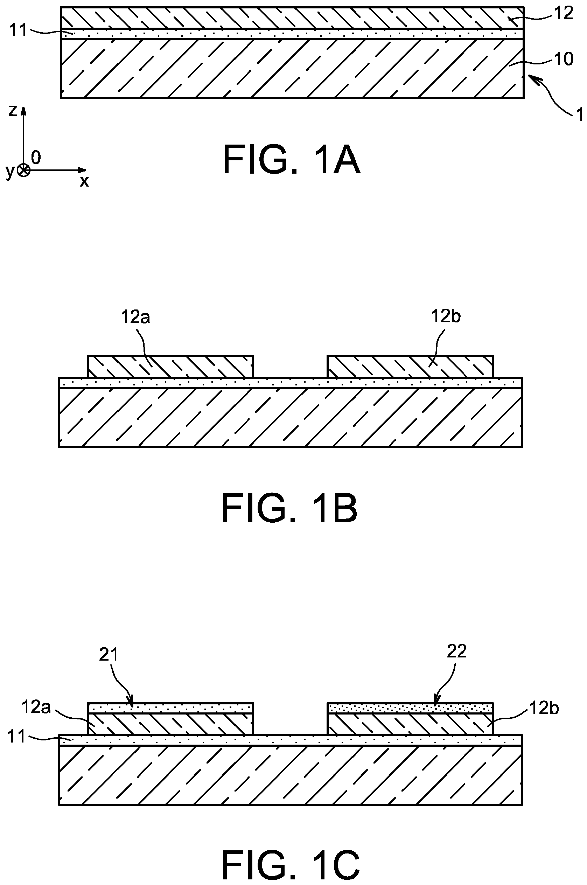

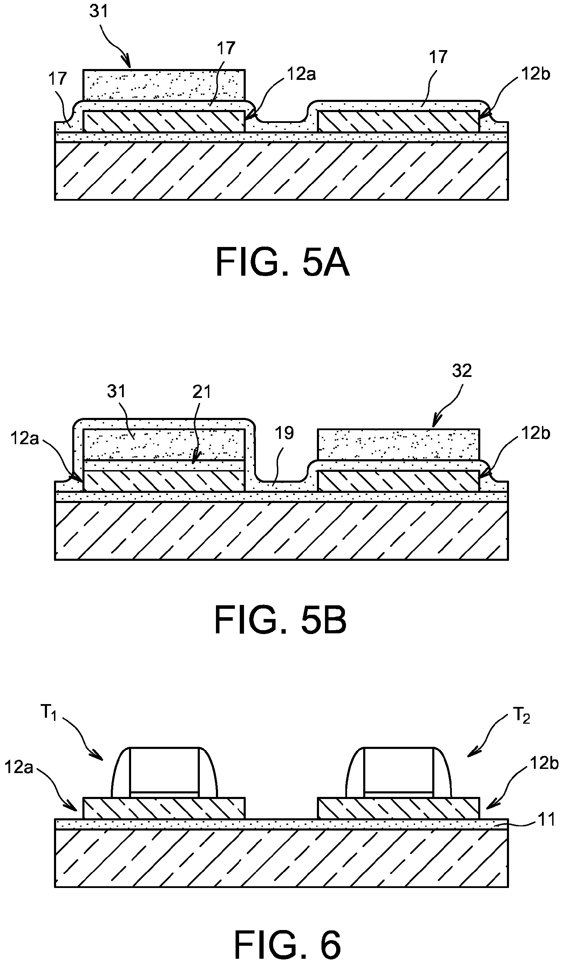

- les figures 1A-1G et 5A-5B illustrent un exemple de procédé suivant l'invention, permettant de former un substrat de type semi-conducteur sur isolant doté en surface de blocs semi-conducteurs contraints à base du même matériau semi-conducteur et reposant sur la couche isolante du substrat, un ou plusieurs premier(s) bloc(s) étant contraint(s) en tension, tandis qu'un ou plusieurs deuxième(s) bloc(s) sont contraint(s) en compression, ou relaxés des contraintes ;

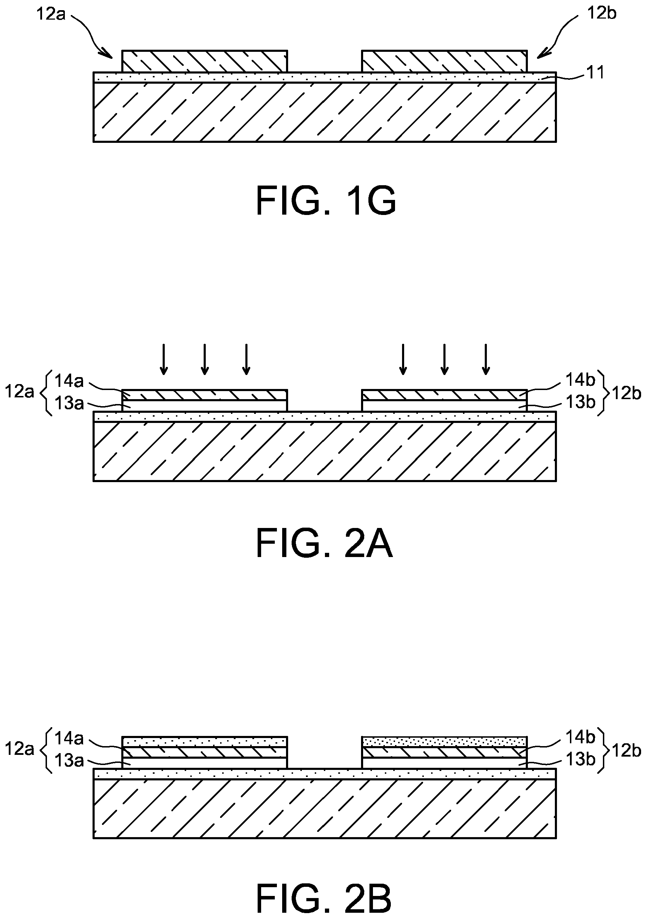

- les figures 2A-2B illustrent une variante de réalisation dans laquelle on réalise une amorphisation de la partie inférieure de blocs semi-conducteurs disposés sur un substrat semi-conducteur sur isolant, puis on forme des zones de mise en contrainte pour induire une contrainte dans ces blocs, avant de recristalliser la partie inférieure des blocs afin d'y réaliser un transfert du paramètre de maille déformée dans le plan d'une partie supérieure non-amorphisée des blocs ;

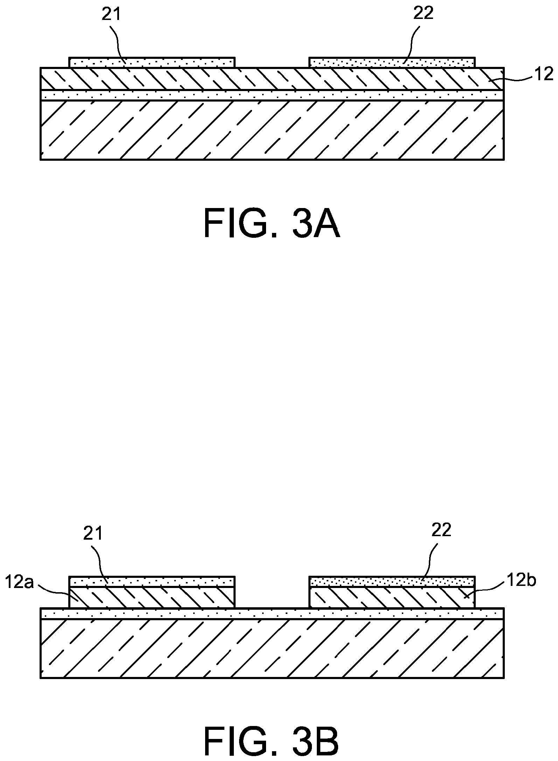

- les figures 3A-3B illustrent une autre variante dans laquelle on forme des zones de contrainte différentes sur une même couche semi-conductrice superficielle d'un substrat semi-conducteur sur isolant ;

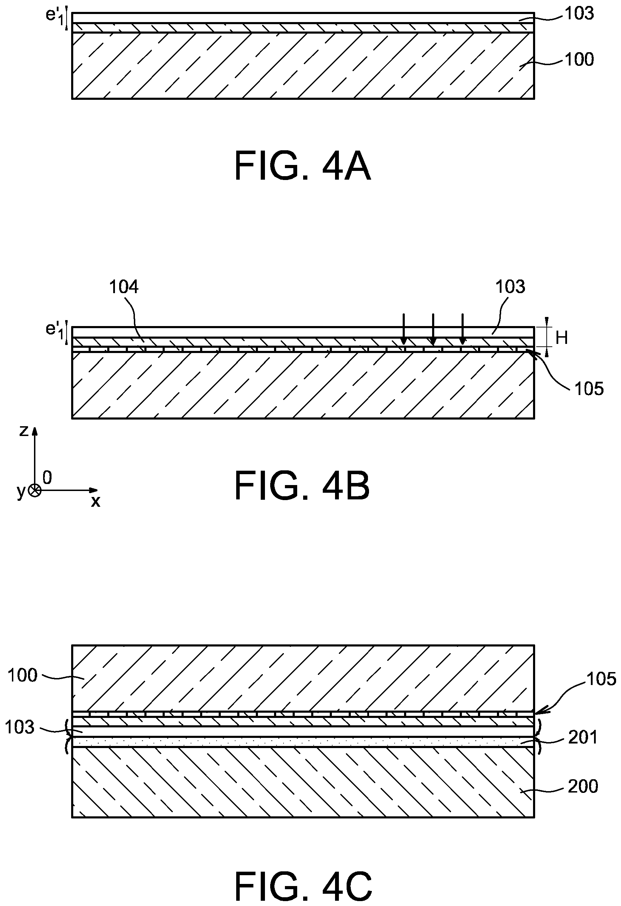

- les figures 4A-4G illustrent une autre variante dans laquelle on réalise sur une couche de matériau semi-conducteur cristallin une couche de matériau semi-conducteur amorphe que l'on vient accoler à une couche isolante afin de former un substrat de type semi-conducteur sur isolant dont la couche semi-conductrice superficielle est formée d'une sous-couche inférieure à base de matériau semi-conducteur amorphe et d'une sous-couche supérieure à base de matériau semi-conducteur cristallin ;
- la figure 6 illustre un dispositif à transistors formé à l'aide d'un procédé suivant l'invention, avec un transistor de type P formé dans un premier bloc semi-conducteur contraint en compression et un transistor de type N formé dans un deuxième bloc semi-conducteur contraint en tension ;

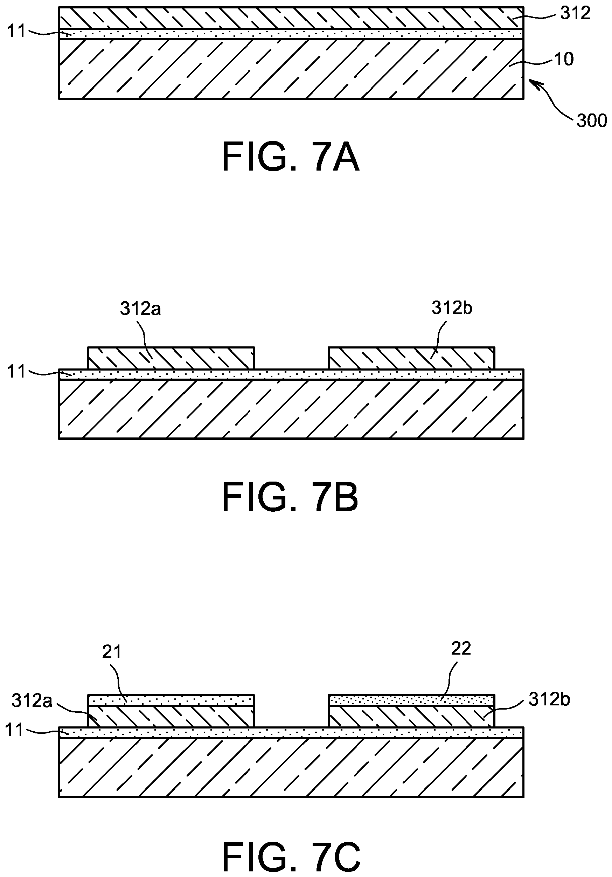

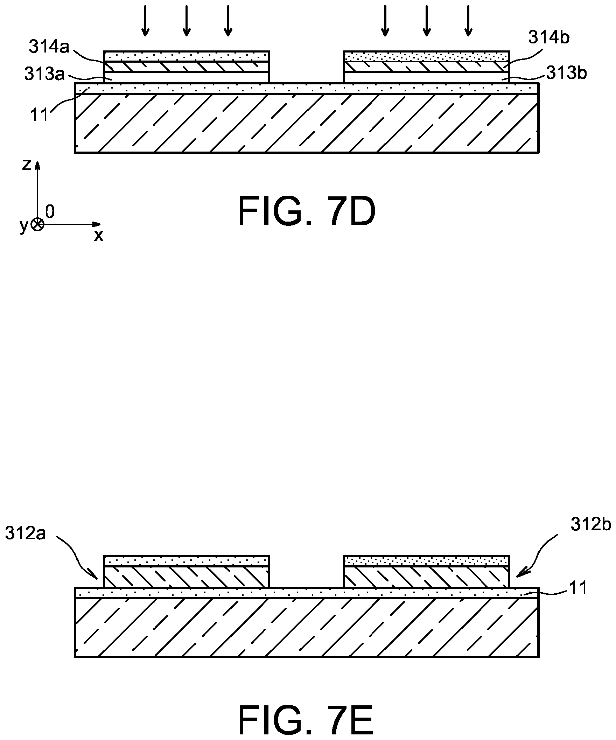

- les figures 7A-7E illustrent une autre variante de réalisation permettant de former, à partir d'un substrat de type semi-conducteur contraint sur isolant, un bloc semi-conducteur relaxé ou contraint en compression et un bloc semi-conducteur contraint en tension reposant sur la couche isolante du substrat ;

Comme cela est usuel dans la représentation des structures semi-conductrices, les diverses vues en coupe ne sont pas tracées à l'échelle. Les différentes parties représentées sur les figures ne le sont pas nécessairement selon une échelle uniforme, pour rendre les figures plus lisibles. En outre, dans la description ci-après, des termes qui dépendent de l'orientation de la structure, tels que « inférieur », « supérieur », s'appliquent en considérant que la structure est orientée de la façon illustrée dans les figures.

### EXPOSÉ DÉTAILLÉ DE MODES DE RÉALISATION PARTICULIERS

Un premier exemple de procédé, suivant l'invention, va à présent être décrit en liaison avec les figures 1A-1G et 5A-5B.

Le matériau de départ de ce procédé est un substrat de type semi-conducteur sur isolant, et peut être par exemple de type SOI (SOI pour « silicon on insulator » ou « silicium sur isolant »).

Le substrat 1 comprend ainsi une couche de support 10 par exemple semi-conductrice, qui peut être à base de Si, ainsi qu'une couche isolante 11, par exemple à base d'oxyde de silicium, qui est située sur et en contact avec la couche de support 10. La couche isolante 11 peut être par exemple de type BOX (BOX pour « Burried Oxide ») avec une épaisseur (mesurée dans une direction parallèle à l'axe z d'un repère orthogonal [O ;x ;y ;z] donné sur la figure 1A) par exemple comprise 10 nm et 100 nm.

Le substrat 1 comporte en outre une couche semi conductrice 12 dite « superficielle » située sur et en contact avec ladite couche isolante 11. Cette couche semi-conductrice superficielle 12, peut avoir une épaisseur par exemple comprise entre 5 nm et 50 nm (figure 1A).

On forme tout d'abord dans la couche semi-conductrice superficielle 12 plusieurs blocs 12a, 12b disjoints par gravure en se servant de la couche isolante 11 comme couche d'arrêt. Les blocs 12a, 12b sont destinés à former une ou plusieurs zones actives permettant d'accueillir des composants ou des parties de composants, par exemple des transistors. La gravure des blocs 12a, 12b peut être effectuée par exemple à l'aide de TMAH (pour « Tetra methyl ammonium hydroxide », par exemple dans le cas où les blocs 12a, 12b sont à base de Silicium (figure 1B).

Ensuite (figure 1C), on forme sur un premier bloc semi-conducteur 12a une première zone de mise en contrainte 21 encore appelée « zone de contrainte » et destinée à induire dans le premier bloc semi-conducteur 12a un premier type de contrainte, par exemple à contraindre le premier bloc semi-conducteur 12a en compression, tandis que sur un deuxième bloc semi-conducteur 12b, une deuxième zone de mise en contrainte 22 encore appelée « zone de contrainte » est formée et destinée à induire dans le deuxième bloc semi-conducteur 12b un deuxième type de contrainte, par exemple à contraindre le deuxième bloc semi-conducteur 12b en tension.

La première zone de contrainte 21 peut être elle-même à base d'un matériau amorphe ayant une contrainte élastique intrinsèque en tension tandis que la deuxième zone de contrainte 22 est à base d'un matériau amorphe ayant une contrainte élastique intrinsèque en compression.

La contrainte exercée sur les blocs 12a, 12b n'est ici pas imposée par un matériau cristallin ayant un paramètre de maille différent de celui du matériau semi-conducteur des blocs 12a, 12b.

La première zone de contrainte 21 et la deuxième zone de contrainte 22 peuvent être à base d'un matériau amorphe contraint tel que par exemple du nitrure de silicium, ou du nitrure de titane, ou du carbone de type DLC (DLC pour « Diamond like Carbon ») ou carbone amorphe tétraédrique (ta-C).

Un exemple de procédé de réalisation des zones contrainte est donné sur les figures 5A-5B.

La première zone de contrainte 21 peut être formée tout d'abord par dépôt d'une première couche 17 à base de matériau amorphe contraint réalisée de manière à recouvrir la couche isolante 11 et les blocs semi-conducteurs 12a, 12b. La première couche 17 peut être par exemple à base de SiₓN_{y} contraint en tension et adapté pour induire sur le premier bloc semi-conducteur 12a une contrainte en compression. La première couche 17 peut avoir une épaisseur comprise par exemple entre 10 nm et 200 nm et une contrainte nominale par exemple de l'ordre de 2 GPa.

Puis, on forme un premier masquage 31 recouvrant le premier bloc 12a et qui comporte une ouverture dévoilant le deuxième bloc 12b (figure 5A). On grave ensuite la première couche de contrainte 17 à travers la ou les ouvertures du premier masquage 31 de manière à conserver une zone de contrainte 21 uniquement sur le premier bloc 12a.

On forme ensuite la deuxième zone de contrainte 22, en déposant une deuxième couche 19 à base de matériau amorphe contraint par exemple à base de Si_{x'}N_{y'} contraint en compression et adapté pour induire sur le deuxième bloc semi-conducteur 12b une contrainte en tension. La deuxième couche 19 de contrainte peut avoir une épaisseur comprise par exemple entre 10 nm et 200 nm et une contrainte nominale par exemple de l'ordre de 2 GPa.

Ce dépôt est réalisé de manière à recouvrir la couche isolante 11 et le bloc semi-conducteur 12b. La deuxième couche 19 à base de matériau amorphe contraint peut recouvrir également le premier masquage formé au-dessus du premier bloc 12a.

Puis, on forme un deuxième masquage 32 recouvrant le deuxième bloc 12b (figure 5B). On grave ensuite la deuxième couche 19 à travers la ou les ouvertures du premier masquage 31 et du deuxième masquage 32 de manière à conserver une zone de contrainte 22 uniquement sur le deuxième bloc 12b et la zone de contrainte 21 uniquement sur le premier bloc 12a. On retire ensuite les masquages 31, 32.

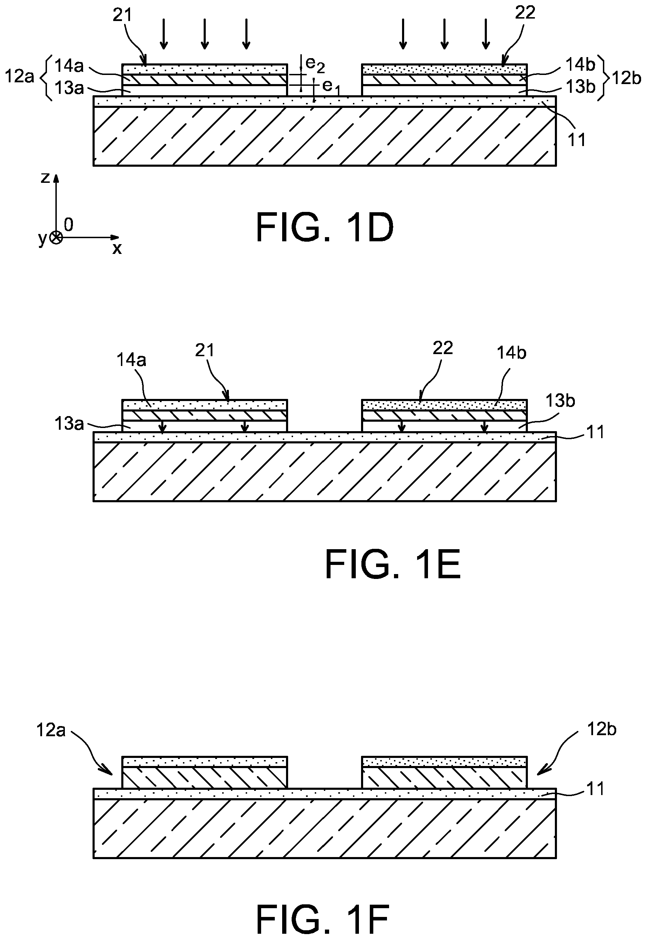

Ensuite (figure 1D), on effectue une amorphisation dite « enterrée » des blocs semi-conducteurs 12a, 12b, de sorte à rendre amorphes des régions 13a, 13b situées dans la partie inférieure des blocs 12a, 12b respectivement sous d'autres régions 14a et 14b situées dans la partie supérieure des blocs 12a, 12b dont la structure cristalline est conservée.

Les régions inférieures 13a, 13b rendues amorphes des blocs 12a, 12b, peuvent s'étendre respectivement sous les régions cristallines 14a, 14b jusqu'à la couche isolante 11 du substrat 1, tandis que les régions supérieures 14a, 14b dont la structure cristalline a été conservée s'étendent respectivement entre les régions inférieures 13a, 13b amorphes et les zones de contrainte 21, 22.

L'amorphisation des régions 13a et 13b peut être effectuée à l'aide d'au moins une étape d'implantation ionique. Dans cet exemple de réalisation, l'implantation amorphisante du matériau semi-conducteur des régions semi-conductrices 13a, 13b est mise en œuvre par exemple à l'aide de Si ou de Ge, par exemple selon une dose comprise entre 1^{E}14 et 1^{E}15 et une énergie comprise entre 2 keV et 100 keV.

Les régions rendues amorphes 13a, 13b peuvent avoir une épaisseur e₁ comprise par exemple entre 50% et 95% de l'épaisseur totale e₁+e₂ des blocs 12a, 12b, tandis que les régions cristallines 14a, 14b peuvent avoir une épaisseur e₂ comprise par exemple entre 50% et 5% de l'épaisseur totale e₁+e₂ des blocs 12a, 12b (les épaisseurs étant mesurées dans une direction parallèle à l'axe z du repère [O,x,y,z] donné sur la figure 1D).

A titre d'exemple, un bloc de Si d'épaisseur de 33 nm peut avoir une région rendue amorphe entre 70% et 80% de son épaisseur inférieure par implantation ionique de Si+ à une énergie de 20 keV et une dose de 3.5 ^{∗} 10¹⁴ atomes/cm².

Les régions supérieures 14a, 14b dont la structure cristalline a été conservée s'étendent respectivement entre les régions inférieures 13a, 13b amorphes et les zones de contrainte 21, 22.

Les zones de contrainte 21, 22 disposées sur et en contact avec respectivement, la région supérieure cristalline 14a du premier bloc 12a et la région supérieure cristalline 14b du deuxième bloc 12b permettent d'induire une contrainte dans le plan importante dans le matériau de ces régions supérieures 14a, 14b.

On réalise ensuite une recristallisation des régions 13a, 13b des blocs 12a, 12b (figure 1E).

Pour cela, on effectue au moins un recuit thermique à une température comprise par exemple entre 450°C et 1300°C, selon une durée comprise par exemple supérieure à 0s et inférieure à 1h.

Des fronts de recristallisation verticaux se dirigeant respectivement des régions supérieures cristallines 14a, 14b jusqu'à la couche isolante 11 sont ainsi créés.

Dans la mesure où les régions 13a, 13b inférieures des blocs 12a, 12b reposent sur une couche amorphe, ce sont les régions cristallines 14a, 14b, mises en contrainte respectivement par les zones de contrainte 21 et 22, qui imposent leur paramètre de maille respectifs aux régions 13a, 13b inférieures des blocs 12a, 12b lors de la recristallisation. Les régions cristallines 14a, 14b imposent ainsi un paramètre de maille déformé dans le plan aux régions 13a, 13b sous-jacentes recristallisées.

De par leur proximité des zones de contraintes 21, 22, les régions cristallines 14a, 14b sont celles des blocs 12a, 12b, qui sont soumises aux déformations de paramètre de maille les plus importantes. A l'issue de la recristallisation (figure 1F), on obtient ainsi des blocs 12a, 12b contraints respectivement en compression et en tension, et dont les contraintes respectives sont supérieures à celles subies juste après l'étape de réalisation des zones de contrainte 21 et 22 décrite précédemment en liaison avec la figure 1C.

Ensuite, on peut retirer les zones de contraintes 21, 22 (figure 1G).

Les blocs 12a, 12b conservent alors respectivement une contrainte en compression et une contrainte en tension.

A partir des blocs 12a, 12b, on peut ensuite former au moins un premier transistor T₁ de type P, par exemple de type PMOS ou PFET, dont le canal est prévu dans le premier bloc 12a contraint en compression et au moins un deuxième transistor T₂ de type N, par exemple de type NMOS ou NFET, dont le canal est prévu dans le deuxième bloc 12b contraint en tension.

Les canaux des transistors T₁ et T₂ sont alors réalisés dans un même matériau semi-conducteur, dans cet exemple du Si (figure 6).

Selon une variante de l'exemple de procédé qui vient d'être décrit, après l'étape d'amorphisation des régions 13a, 13b des blocs 12a, 12b et préalablement au recuit de recristallisation décrit en liaison avec la figure 1E, on peut prévoir préalablement au moins un recuit à une température prévue inférieure à la température de cristallisation du matériau semi-conducteur des blocs 12a, 12b.

Ce recuit peut être réalisé à une température comprise par exemple entre 280°C et 400°C, pendant une durée comprise par exemple entre 30 s et 5 h.

Un ou plusieurs recuits préalablement à l'étape de recristallisation peuvent permettre d'augmenter au final la contrainte induite dans les blocs 12a, 12b.

Un dispositif tel qu'illustré sur la figure 1F comprenant sur et en contact avec la couche isolante 11 d'un substrat de type semi-conducteur sur isolant, un premier bloc semi-conducteur 12a contraint en compression et un deuxième bloc semi-conducteur 12b contraint en tension et à base du même matériau semi-conducteur que le premier bloc, peut être réalisé en suivant un enchainement d'étapes ayant un ordre différent de celui qui vient d'être donné.

Par exemple, selon une variante (figures 2A-2B) du procédé qui vient d'être décrit, on peut réaliser l'étape dite d'amorphisation enterrée (figure 2A) avant celle consistant à former les zones de contrainte 21, 22 respectivement sur les régions 14a, 14b des blocs 12a, 12b qui n'ont pas été rendues amorphes et dont la structure cristalline a ainsi été conservée (figure 2B).

Selon une autre variante (figures 3A-3B) des exemples de procédé qui viennent d'être donnés, on peut réaliser l'étape de formation des zones 21, 22 de contrainte avant celle de gravure de la couche semi-conductrice 12 du substrat.

On forme ainsi la première zone de contrainte 21 sur une zone de la couche semi-conductrice superficielle 12 du substrat, et la deuxième zone de contrainte 22 sur une autre zone de cette couche semi-conductrice superficielle 12 (figure 3A).

Puis, on effectue une gravure de la couche semi-conductrice superficielle 12 du substrat entre les zones de contrainte 21 et 22, de manière à former les blocs semi-conducteurs 12a, 12b disjoints reposant sur la couche isolante 11 du substrat (figure 3B). La gravure peut être réalisée par exemple à l'aide de TMAH lorsque la couche 12 est à base de Si.

Selon un autre exemple de réalisation donné sur les figures 4A-4G, on peut réaliser les régions 13a, 13b amorphisées des blocs semi-conducteurs 12a, 12b, avant l'étape consistant à délimiter ces blocs par gravure de la couche semi-conductrice superficielle 12 d'un substrat.

On forme ainsi tout d'abord, sur un support 100, par exemple un substrat massif à base de Si cristallin (« bulk » selon la terminologie anglo-saxonne), une couche de matériau semi-conducteur amorphe 103, en particulier une couche de Si amorphe (figure 4A).

Cette couche de matériau semi-conducteur amorphe 103 peut être réalisée par amorphisation, par exemple en réalisant une implantation ionique d'une couche superficielle du substrat 100, ou par dépôt d'une couche de matériau semi-conducteur amorphe sur le substrat 100.

La couche de matériau semi-conducteur amorphe 103 peut avoir une épaisseur e'₁ (mesurée dans une direction parallèle à l'axe z) du repère orthogonal [O ;x ;y ;z] donné sur la figure 4A par exemple comprise entre 5 nm et 200 nm.

Ensuite, on forme une zone de fragilisation 105 dans le substrat 100, par exemple en réalisant une implantation d'Hydrogène telle que mise en œuvre dans un procédé de type communément appelé smart cut^{™}.

L'implantation est réalisée à une profondeur H (mesurée dans une direction parallèle à l'axe z sur la figure 4B à partir d'une face supérieure encore appelée face avant du substrat 100 par laquelle on effectue l'implantation) supérieure à l'épaisseur e'₁ de la couche de matériau semi-conducteur amorphe, de manière à conserver une couche de matériau semi-conducteur cristallin 104 intacte d'épaisseur non-nulle entre la couche rendue amorphe 103 et la zone de fragilisation 105.

On colle ensuite (figure 4C) la couche de matériau semi-conducteur amorphe 103 du substrat 100 avec une couche isolante 201 superficielle, par exemple à base de SiO₂, d'un autre substrat 200. Ce collage est réalisé de préférence à une température choisie inférieure à un seuil donné, qui dépend notamment du type de matériau semi-conducteur 103 rendu amorphe, de manière à empêcher une recristallisation de ce matériau semi-conducteur 103. La température à laquelle le collage est effectué peut être par exemple choisie inférieure à 500°C.

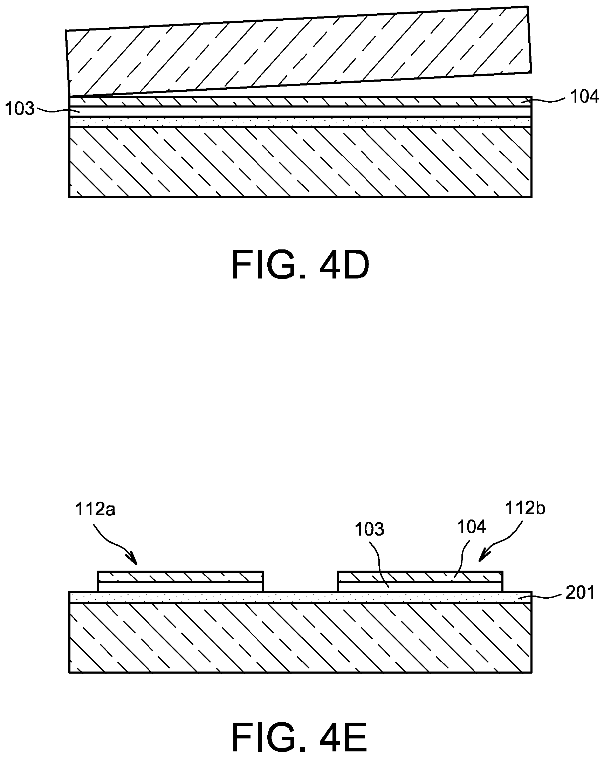

On effectue ensuite un recuit à une température inférieure audit seuil donné, par exemple de 500°C, et on réalise une fracturation du substrat 100 au niveau de sa zone de fragilisation 105, de manière à ne conserver que la couche semi-conductrice 104 du substrat 100 en contact avec la couche de matériau semi-conducteur amorphe 103, le reste du substrat 100 étant retiré (figure 4D).

Une étape de planarisation, par exemple par polissage mécano-chimique (CMP) peut être ensuite réalisée pour réduire l'épaisseur de la couche semi-conductrice 104.

Ensuite, on forme des blocs 112a, 112b disjoints par gravure de la couche de matériau semi-conducteur cristallin 104 et de la couche de matériau amorphe 103 jusqu'à atteindre la couche isolante 201 (figure 4E).

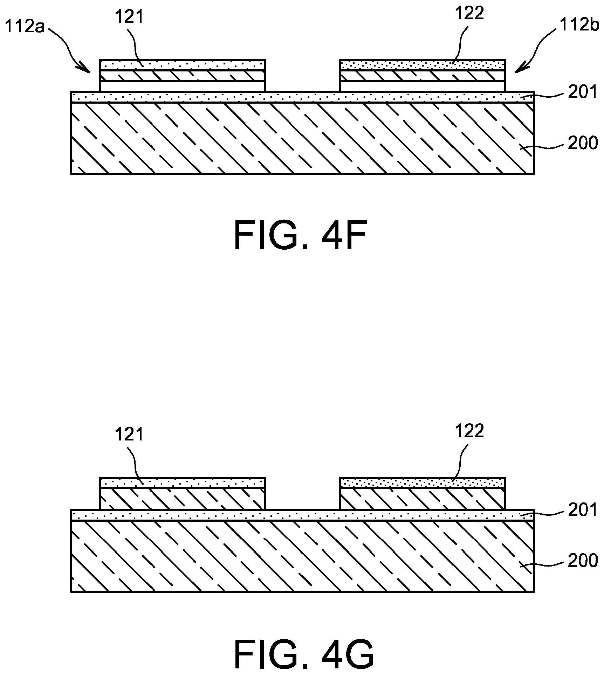

Sur un premier bloc semi-conducteur 112a, on forme une première zone contrainte 121, par exemple à base de nitrure de silicium contraint en tension, adaptée pour induire une contrainte en compression dans ce premier bloc 112a, tandis que sur un deuxième bloc 112b, on forme une deuxième zone contrainte, par exemple à base de nitrure de silicium contraint en compression, adaptée pour induire une contrainte en tension dans le deuxième bloc 112b (figure 4F).

Ensuite, on effectue une recristallisation de régions de matériau semi-conducteur amorphe 103 des blocs 112a, 112b en se servant de zones de la couche de matériau semi-conducteur cristallin 104 comme zone de départ d'un front de recristallisation. La recristallisation des blocs 112a, 112b permet également de transférer le paramètre de maille de leur partie supérieure à base de matériau semi-conducteur cristallin subissant une contrainte exercée par les zones 121, 122, vers leur partie inférieure (figure 4G).

Un procédé tel que mis en œuvre en œuvre suivant l'invention n'est pas limité à la mise en contrainte de blocs de silicium et peut s'appliquer à d'autres matériaux semi-conducteurs tels que le Ge, le SiₓGe₁₋ₓ, l'InP, le GaAs.

Un procédé tel que décrit précédemment en liaison avec les figures 1A-1G peut également être mis en œuvre à l'aide d'un substrat semi-conducteur contraint sur isolant 300 (figure 7A), en particulier de type sSOI (pour « strained Silicon On Insulator » ou « silicium contraint sur isolant ») doté d'une couche semi conductrice 312 superficielle à base de Si qui est contrainte, par exemple en tension, et située sur et en contact avec la couche isolante 11 du substrat 300.

On forme dans la couche semi conductrice 312 superficielle contrainte un premier bloc 312a et un deuxième bloc 312b (figure 7B), puis on réalise sur le premier bloc semi-conducteur 312a une première zone de contrainte 21 tandis que sur le deuxième bloc semi-conducteur 312b, une deuxième zone de contrainte 22 est formée (figure 7C).

La première zone de contrainte 21 peut être formée de matériau amorphe tel que par exemple du SiₓN_{y}, ayant une contrainte intrinsèque en tension ayant tendance à s'opposer à la contrainte en tension initiale du premier bloc 312a.

La deuxième zone de contrainte 22 peut, quant à elle, être formée de matériau amorphe contraint en compression tel que par exemple du SiₓN_{y}. La deuxième zone de contrainte 22 peut ainsi permettre d'augmenter la contrainte initiale du deuxième bloc 312b.

Ensuite, on réalise une étape d'amorphisation enterrée des blocs semi-conducteurs 312a, 312b (figure 7D), de sorte à rendre amorphes des régions 313a, 313b inférieures des blocs 312a, 312b respectivement sous d'autres régions 314a, 314b supérieures des blocs 312a, 312b et dont la structure cristalline est conservée.

On effectue ensuite une recristallisation des blocs semi-conducteurs 312a, 312b. Lors de cette recristallisation, les régions 314a, 314b supérieures des blocs 312a, 312b qui sont situées directement sous les zones de contrainte 21 et 22 imposent leur paramètre de maille aux régions inférieures 313a, 313b.

On peut ainsi obtenir, après recristallisation, une structure semi-conductrice dans laquelle le deuxième bloc semi-conducteur 312b est contraint en tension et dans laquelle le premier bloc semi-conducteur 312a est relaxé ou contraint en compression en fonction notamment du niveau de contrainte intrinsèque du matériau de la première zone de contrainte 21, et donc de l'état initial de contrainte du premier bloc semi-conducteur 312a avant amorphisation.

Selon une autre variante de l'un ou l'autre des exemples de procédé qui viennent d'être décrits, on peut réaliser des étapes d'amorphisation du premier bloc et du deuxième bloc semi-conducteur, puis de recristallisation ladite région inférieure du premier bloc et dudit deuxième bloc en servant de ladite région supérieure de matériau cristallin comme zone de départ à un front de recristallisation, ce sans effectuer de gravure de la couche dans lequel ces blocs sont situés.

## Revendications

1. Procédé comprenant des étapes consistant à :
a) former sur une couche isolante d'un substrat de type semi-conducteur sur isolant, un premier bloc semi-conducteur (12a, 112a) recouvert d'une première zone de contrainte (21, 121) à base d'un matériau amorphe contraint en tension adapté pour induire un premier état de contrainte dans ledit premier bloc et un deuxième bloc semi-conducteur (12b, 112b) recouvert d'une deuxième zone de contrainte (22, 122) à base d'un matériau amorphe contraint en compression adapté pour induire un deuxième état de contrainte dans ledit deuxième bloc, le premier bloc et le deuxième bloc étant formés chacun d'une région inférieure (13a, 13b, 103) à base de matériau semi-conducteur amorphe, la région inférieure étant recouverte d'une région supérieure de matériau semi-conducteur cristallin (14a, 14b, 104) en contact avec une desdites zones de contrainte,
b) recristalliser ladite région inférieure (13a, 13b, 103) dudit premier bloc et dudit deuxième bloc en se servant de ladite région supérieure (14a, 14b, 104) de matériau cristallin comme zone de départ à un front de recristallisation.

2. Procédé selon la revendication 1, dans lequel l'étape a) est effectuée par une implantation amorphisante de la région inférieure (13a, 13b, 103) du premier bloc et du deuxième bloc, ladite implantation étant réalisée de manière à conserver la structure cristalline de ladite région supérieure (14a, 14b, 104).

3. Procédé selon la revendication 1, dans lequel l'étape a) comprend une gravure d'un empilement formé d'une couche de matériau semi-conducteur cristallin (104) reposant sur une couche de matériau semi-conducteur amorphe (103).

4. Procédé selon la revendication 3, dans lequel ledit empilement est préalablement formé par des étapes consistant à :
- réaliser, par dépôt ou par implantation amorphisante, une couche de matériau semi-conducteur amorphe (103) reposant sur une couche à base de matériau cristallin (104) et appartenant à un premier substrat (100),
- coller ladite couche de matériau semi-conducteur amorphe (103) sur une couche isolante (202) superficielle recouvrant un deuxième substrat (200).

5. Procédé selon l'une des revendications 1 à 4, dans lequel ledit matériau contraint amorphe est à base de SiₓN_{y} ou de TiN ou de carbone.

6. Procédé selon l'une des revendications 1 à 5, dans lequel la réalisation de la première zone de contrainte et/ou de la deuxième zone de contrainte comprend des étapes de :
- dépôt d'une couche de matériau contraint sur ledit premier bloc et sur ledit deuxième bloc,
- formation d'un masquage recouvrant un bloc donné parmi le premier bloc et le deuxième bloc, une ouverture dudit masquage dévoilant un autre bloc parmi le premier bloc et le deuxième bloc,
- gravure de l'autre bloc à travers l'ouverture du masquage.

7. Procédé selon l'une des revendications 1 à 6, dans lequel le premier bloc et ledit deuxième bloc sont à base du même matériau semi-conducteur.

8. Procédé selon l'une des revendications 1 à 7, le premier état de contrainte dans le premier bloc semi-conducteur étant tel que le premier bloc semi-conducteur est contraint en compression le deuxième état de contrainte dans ledit deuxième bloc étant tel que le deuxième bloc est semi-conducteur est contraint en tension.

9. Procédé selon l'une des revendications 1 à 8, dans lequel ledit substrat est un substrat de type semi-conducteur contraint en tension sur isolant, le premier état de contrainte dans ledit premier bloc étant tel que le premier bloc est relaxé le deuxième état de contrainte dans ledit deuxième bloc étant tel que le deuxième bloc est contraint en tension.

10. Procédé selon l'une des revendications 1 à 9, comprenant en outre, entre l'étape a) et l'étape b), au moins un recuit thermique effectué à une température inférieure à la température de recristallisation du matériau semi-conducteur amorphe.

## Patentansprüche

1. Verfahren, umfassend die folgenden Schritte:
a) Bilden, auf einer isolierenden Schicht eines Substrats vom Typ Halbleiter auf Isolator, eines ersten Halbleiterblocks (12a, 112a), der mit einer ersten Verspannungszone (21, 121) auf Basis eines zugverspannten amorphen Materials bedeckt ist, das dazu ausgelegt ist, einen ersten Verspannungszustand in den ersten Block zu induzieren, und eines zweiten Halbleiterblocks (12b, 112b), der mit einer zweiten Verspannungszone (22, 122) auf Basis eines kompressionsverspannten amorphen Materials bedeckt ist, das dazu ausgelegt ist, einen zweiten Verspannungszustand in den zweiten Block zu induzieren, wobei der erste Block und der zweite Block jeweils mit einer unteren Region (13a, 13b, 103) auf Basis von amorphem Halbleitermaterial gebildet sind, wobei die untere Region bedeckt ist mit einer oberen Region von kristallinem Halbleitermaterial (14a, 14b, 104) in Kontakt mit einer der Verspannungszonen,
b) Rekristallisieren der unteren Region (13a, 13b, 103) des ersten Blocks und des zweiten Blocks, wobei man sich der oberen Region (14a, 14b, 104) von kristallinem Material als Ausgangszone für eine Rekristallisationsfront bedient.

2. Verfahren nach Anspruch 1, bei dem der Schritt a) durch eine amorphisierende Implantierung der unteren Region (13a, 13b, 103) des ersten Blocks und des zweiten Blocks durchgeführt wird, wobei die Implantierung derart realisiert wird, dass die kristalline Struktur der oberen Region (14a, 14b, 104) bewahrt bleibt.

3. Verfahren nach Anspruch 1, bei dem der Schritt a) ein Ätzen eines Stapels umfasst, gebildet aus einer Schicht aus kristallinem Halbleitermaterial (104), die auf einer Schicht aus amorphem Halbleitermaterial (103) ruht.

4. Verfahren nach Anspruch 3, bei dem der Stapel zuvor durch die folgenden Schritte gebildet wird:
- Realisieren, durch Abscheidung oder durch amorphisierende Implantierung, einer Schicht aus amorphem Halbleitermaterial (103), die auf einer Schicht auf Basis von kristallinem Material (104) ruht und zu einem ersten Substrat (100) gehört,
- Kleben der Schicht aus amorphem Halbleitermaterial (103) auf eine isolierende Oberflächenschicht (202), die ein zweites Substrat (200) bedeckt.

5. Verfahren nach einem der Ansprüche 1 bis 4, bei dem das amorphe verspannte Material auf Basis von SiₓN_{y} oder von TiN oder von Kohlenstoff ist.

6. Verfahren nach einem der Ansprüche 1 bis 5, bei dem die Realisierung der ersten Verspannungszone und/oder der zweiten Verspannungszone die folgenden Schritte umfasst:
- Abscheiden einer verspannten Materialschicht auf dem ersten Block und auf dem zweiten Block,
- Bilden einer Maskierung, die einen gegebenen Block aus dem ersten Block und dem zweiten Block bedeckt, wobei eine Öffnung der Maskierung einen anderen Block aus dem ersten Block und dem zweiten Block aufdeckt,
- Ätzen des anderen Blocks durch die Öffnung der Maskierung hindurch.

7. Verfahren nach einem der Ansprüche 1 bis 6, bei dem der erste Block und der zweite Block auf Basis des gleichen Halbleitermaterials sind.

8. Verfahren nach einem der Ansprüche 1 bis 7, wobei der erste Verspannungszustand in dem ersten Halbleiterblock derart ist, dass der erste Halbleiterblock kompressionsverspannt ist, wobei der zweite Verspannungszustand in dem zweiten Block derart ist, dass der zweite Halbleiterblock zugverspannt ist.

9. Verfahren nach einem der Ansprüche 1 bis 8, bei dem das Substrat ein Substrat vom Typ zugverspannter Halbleiter auf Isolator ist, wobei der erste Verspannungszustand in dem ersten Block derart ist, dass der erste Block relaxiert ist, wobei der zweite Verspannungszustand in dem zweiten Block derart ist, dass der zweite Block zugverspannt ist.

10. Verfahren nach einem der Ansprüche 1 bis 9, ferner umfassend zwischen dem Schritt a) und dem Schritt b) wenigstens ein thermisches Glühen, das bei einer Temperatur unterhalb der Rekristallisationstemperatur des amorphen Halbleitermaterials durchgeführt wird.

## Claims

1. A method comprising the steps consisting in:
a) forming on an insulating layer of a semi-conductor on insulator type substrate, a first semi-conductor block (12a, 112a) covered with a first strain zone (21, 121) based on a tensile strained amorphous material adapted to induce a first strain state in said first block and a second semi-conductor block (12b, 112b) covered with a second strain zone (22, 122) based on a compressive strained amorphous material adapted to induce a second strain state in said second block, the first block and the second block each being formed of a lower region (13a, 13b, 103) based on amorphous semi-conductor material, the lower region being covered with an upper region of crystalline semi-conductor material (14a, 14b, 104) in contact with one of said strain zones,
b) recrystallizing said lower region (13a, 13b, 103) of said first block and of said second block while using said upper region (14a, 14b, 104) of crystalline material as starting zone for a recrystallization front.

2. The method according to claim 1, wherein step a) is carried out by an amorphizing implantation of the lower region (13a, 13b, 103) of the first block and of the second block, said implantation being carried out so as to conserve the crystalline structure of said upper region (14a, 14b, 104).

3. The method according to claim 1, wherein step a) comprises an etching of a stack formed of a layer of crystalline semi-conductor material (104) resting on a layer of amorphous semi-conductor material (103).

4. The method according to claim 3, wherein said stack is formed beforehand by the steps consisting in:
- forming, by deposition or by amorphizing implantation, a layer of amorphous semi-conductor material (103) resting on a layer based on crystalline material (104) and belonging to a first substrate (100),
- bonding said layer of amorphous semi-conductor material (103) onto a superficial insulating layer (202) covering a second substrate (200).

5. The method according to any of the claims 1 to 4, wherein said amorphous strained material is based on SiₓN_{y} or TiN or carbon.

6. The method according to any of the claims 1 to 5, wherein the formation of the first strain zone and/or of the second strain zone comprises the steps of:
- deposition of a layer of strained material on said first block and on said second block,
- formation of a masking covering a given block among the first block and the second block, an opening of said masking revealing another block among the first block and the second block,
- etching the other block through the opening of the masking.

7. The method according to any of the claims 1 to 6, wherein the first block and said second block are based on the same semi-conductor material.

8. The method according to any of the claims 1 to 7, the first strain state in the first semi-conductor block being such that the first semi-conductor block is compressive strained the second strain state in said second block being such that the second semi-conductor block is tensile strained.

9. The method according to any of the claims 1 to 8, wherein said substrate is a tensile strained semi-conductor on insulator type substrate, the first strain state in said first block being such that the first block is relaxed the second strain state in said second block being such that the second block is tensile strained.

10. The method according to any of the claims 1 to 9, further comprising, between step a) and step b), at least one thermal annealing carried out at a temperature below the recrystallization temperature of the amorphous semi-conductor material.
